# EUROPEAN PATENT APPLICATION

(11) **EP 1 791 252 A1**
(43) Date of publication of application: **30.05.2007**
(21) Application number: 05111220.9
(22) Date of filing: 24.11.2005
(51) Int. Cl.: H03B 5/06, H03L 3/00

(54) **Oscillator comprising a startup control device**

(71) Applicant: TELEFONAKTIEBOLAGET LM ERICSSON (publ), 164 83 Stockholm (SE)
(72) Inventor: Isberg, Martin, 224 72, LUND (SE)
(74) Representative: Asketorp, Göran

(57) **Abstract**

An oscillator device (1) comprises an oscillator core (2), a capacitive loading unit (3,3a,3b) having a controllable capacitance value and being connected to the oscillator core (2), and a memory device (4) including a first and a second memory unit (5a,5b) and being connected to the capacitive loading unit. The first memory unit (5a) is adapted to store a first value to be supplied to the capacitive loading unit (3,3a,3b) for controlling the capacitance value during a start-up time period. The second memory unit (5b) is adapted to store a second value to be supplied to the capacitive loading unit (3,3a,3b) for controlling the capacitance value during an operational time period. A method for start up of the oscillator device (1) is also disclosed.

## Description

### Technical Field of the Invention

The present invention relates to an oscillator device comprising an oscillator core and a capacitive loading unit having a controllable capacitance value.

### Description of Related Art

An oscillator device, such as a crystal oscillator, may be used to establish an operating frequency on which various units in a communication device are to operate. In a battery powered communication device, the power consumption is a critical parameter. Therefore, when there is no need for an oscillator signal, the oscillator device may be switched to a stand-by mode to save power.

The oscillator device may be used to generate a high-precision clock signal with low noise. To obtain a high-precision clock signal, a tank circuit with very high Q-value, typically based on a crystal, may be used. This results in that the start-up time may be relatively long (several ms). Hence, at start-up of the oscillator device, it may take some time before a useful oscillator signal has been generated. A useful oscillator signal may e.g. be a signal having a predetermined minimum amplitude or a predetermined frequency accuracy. The oscillator signal may be used as a system clock signal. One way to minimize power consumption is to provide a short start-up time of the oscillator device, thereby allowing the oscillator to be switched into stand-by mode often without loss of overall system performance.

The oscillator device may be implemented with an oscillator core connected to a capacitive loading unit. The capacitive loading unit may be controlled to provide different capacitive loading in response to a control signal. When designing the oscillator device, a compromise may have to be made concerning the capacitive loading resulting in a trade-off between tuning range and start-up time of the oscillator device. The tuning range may be set by the difference between the maximum and minimum capacitance value provided by the capacitive loading unit. However, the start-up time is, e.g. dependent on the minimum capacitance value provided by the capacitive loading unit. Thus, the tuning range may have some influence on the start-up time. Furthermore, the tuning range defines how much component parameter spread of components of the oscillator device, temperature variation and crystal aging that can be handled. Since the start-up time is dependent on the capacitive loading, it is desired to have as low minimum capacitive loading as possible to obtain a short start-up time.

The capacitive loading unit may be controllable to provide a first capacitive loading during start-up. Once the oscillator device is generating a useful oscillator signal, the capacitive loading unit may be controlled to provide a second capacitive loading giving the desired frequency of oscillation.

The capacitive loading unit may be controlled by a processor running software for the control. The processor may control the capacitive loading unit to provide either the first or the second capacitive loading. It is a disadvantage with this solution in that it put requirements on the system design, such as software, that is used to control start-up of the oscillator device, which makes it complex. If the system to which the oscillator device is connected comprises more than one user device of the oscillator signal, and each user device may request start-up of the oscillator device, the system design may become even more complex. The system may also become expensive to manufacture, as each user device e.g. needs software for controlling the start-up of the oscillator device.

US-A-5 844 448 discloses an oscillator circuit for providing fast start-up. The oscillator circuit comprises a first and a second bank of capacitors connected to a crystal. Only the first bank of capacitors is applied during start-up. The second bank of capacitors is controllable and may be switched in when the oscillator output has stabilized at a first oscillation frequency. A processor may be provided to control when the second bank of capacitors should be switched in to provide a desired oscillation frequency. The design according to this document is complex, as it involves a processor requiring software for the control of the start-up. Furthermore, the control of the start-up is based on the detection of the oscillation frequency of the oscillator device. The oscillation frequency is relatively complex to determine, as a reference clock may be required. Consequently, if the signal provided by the oscillator device is the first clock signal in a system in which the oscillator device is implemented, it may become difficult or even impossible to detect the oscillation frequency.

US-A-6 747 522 discloses a method of tuning a DCXO (Digitally Controlled Crystal Oscillator) by providing a coarse tuning array and a fine tuning array of capacitors. Each of the coarse and the fine tuning array of capacitors is tunable to provide a desired operating frequency. Control for short start-up time is not described in this document.

### Summary of the Invention

It is an object of the invention to provide an oscillator device with reduced complexity.

According to a first aspect, an oscillator device comprises an oscillator core and a capacitive loading unit having a controllable capacitance value and being connected to the oscillator core. The oscillator device may further comprise a memory device including a first and a second memory unit and being connected to the capacitive loading unit. The first memory unit is adapted to store a first value to be supplied to the capacitive loading unit for controlling the capacitance value during a first time period. The second memory unit is adapted to store a second value to be supplied to the capacitive loading unit for controlling the capacitance value during a second time period.

The memory device may include at least one control terminal for receiving a first and a second control signal, and may be adapted to supply the first value to the capacitive loading unit in response to the first control signal and to supply the second value to the capacitive loading unit in response to the second control signal.

The oscillator core may be adapted to generate at least the second control signal, which is dependent on the amplitude of an oscillator signal of the oscillator device.

The oscillator core may include an amplitude detection unit adapted to generate at least the second control signal in dependence of the amplitude of the oscillator signal.

The amplitude detection unit may be adapted to generate the second control signal when the amplitude of the oscillator signal exceeds a predefined threshold value.

The amplitude detection unit may form part of an Automatic Gain Control unit.

The amplitude detection unit may comprise a clock squarer operatively connected to an oscillator output and to a counter. The clock squarer may be adapted to generate a square wave in response to that the amplitude of said oscillator signal exceeds a predefined threshold value. The counter may be adapted to start counting when the clock squarer starts to generate the square wave and to generate the second control signal when it reaches a stop value.

The stop value of the counter may be programmable.

The oscillator core may include a delay circuit adapted to generate the second control signal in response to an enable signal and within a predetermined time period after having received the enable signal.

The first and second memory units may be registers.

The capacitive loading unit may include at least one digitally controllable capacitor circuit.

Each digitally controllable capacitor circuit may include at least one capacitor ladder.

The oscillator device may further comprise an input interface circuit adapted to provide the enable signal in response to a start-up request.

The input interface circuit may be connected to at least one external device adapted to generate the start-up request.

According to a second aspect, an electronic device comprises the oscillator device.

The electronic device may be a portable or handheld mobile radio communication equipment, a mobile radio terminal, a mobile telephone, a pager, a communicator, an electronic organizer, a smartphone or a computer.

According to a third aspect, a method for start-up of an oscillator device is provided, the oscillator device including an oscillator core, a capacitive loading unit having a controllable capacitance value and being connected to the oscillator core, a memory device operatively connected to the capacitive loading unit and to the oscillator core, the memory device including a first and a second memory unit. The method comprises supplying a first value stored in the first memory unit to the capacitive loading unit for controlling the controllable capacitance value during the first time period and supplying a second value stored in the second memory unit to the capacitive loading unit for controlling the capacitance value during the second time period.

The method may include the step of determining the starting-time instant for the second time period.

The step of determining the starting-time instant for the second time period may include measuring the amplitude of an oscillator signal and choosing the starting-time instant for the second time period as the time instant when the oscillator signal exceeds a predetermined threshold value.

The step of determining the starting-time instant for the second time period may include receiving an enable signal at the oscillator core and choosing the starting-time instant for the second time period as a time instant occurring a predetermined amount of time after the reception of the enable signal.

Further embodiments of the invention are defined in the dependent claims.

It is an advantage of the invention that control of start-up is flexible, as control values for the capacitive loading unit are stored in the memory device. It is a further advantage of the invention that the complexity of the control of short start-up time of the oscillator device is low, resulting in an overall reduced complexity of the oscillator device and of a system in which the oscillator device may operate.

It should be emphasized that the term "comprises/comprising" when used in this specification is taken to specify the presence of stated features, integers, steps or components but does not preclude the presence or addition of one or more other features, integers, steps, components or groups thereof.

### Brief Description of the Drawings

Further objects, features and advantages of the invention will appear from the following detailed description of embodiments of the invention, reference being made to the accompanying drawings, in which:
Fig. 1 is a block diagram of an embodiment of the oscillator device;
Fig. 2 is a block diagram of another embodiment of the oscillator device;
Fig. 3 is a block diagram of another embodiment of the oscillator device;
Fig. 4 is a circuit diagram of an embodiment of a differential crystal oscillator;
Fig. 5 is a circuit diagram of an embodiment of an amplitude detection unit;
Fig. 6 is a block diagram of another embodiment of the oscillator device;
Figs. 7a-7b are embodiments of amplitude detection units for the embodiment in Fig. 6;
Figs. 8a-8b are circuit diagrams of capacitor ladders;
Fig. 9 is a block diagram of an embodiment of the operational environment of the oscillator device;
Fig. 10 is schematic view of a communication device; and
Fig. 11 is a flow chart for a method of starting up the oscillator device.

### Detailed Description of Embodiments

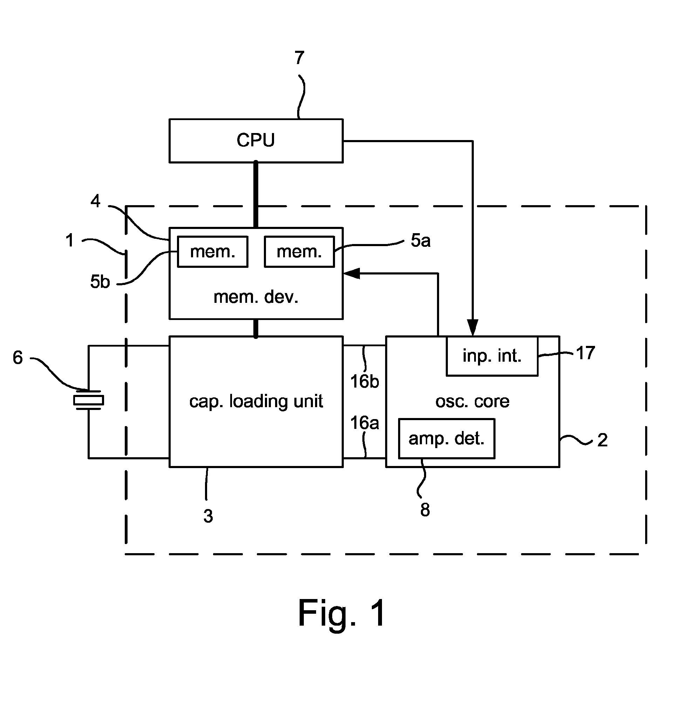

Fig. 1 illustrates a first embodiment of an oscillator device 1, which may form a digitally controlled crystal oscillator (DCXO). The oscillator device 1 comprises an oscillator core 2, and a capacitive loading unit 3. The capacitive loading unit 3 has a controllable capacitance value and is connected to the oscillator core 2. Furthermore, the oscillator device 1 comprises a memory device 4, which includes at least a first and a second memory unit 5a, 5b and which is connected to the capacitive loading unit 3.

The capacitive loading unit may be connected to a crystal 6. The crystal 6 may be located off a chip on which the oscillator device 1 is located.

The first memory unit 5a is adapted to store a first value to be supplied to the capacitive loading unit 3 for controlling the capacitance value of the capacitive loading unit 3 during a first time period. The first time period may be a start-up phase of the oscillator device 1. The second memory unit 5b is adapted to store a second value to be supplied to the capacitive loading unit 3 for controlling the capacitance value of the capacitive loading unit 3 during a second time period. The second time period may be an operational phase of the oscillator device 1.

In the embodiments illustrated in the figures, components, which are similar or the same in the embodiments, are denoted by the same or similar reference numerals and will only be described once.

By providing the memory device 4 for storing the first and the second value, it is possible to provide short start-up time without the need to supply a value for setting the capacitance value of the capacitive loading unit 3 from an external device. Thus, the flexibility of the oscillator device is enhanced. Software for supplying the capacitance value to the capacitive loading unit 3 during the first time period will not be necessary. Consequently, the complexity of a system in which the oscillator device 1 may operate will be decreased.

The memory device 4 may include at least one control terminal for receiving a first and a second control signal. Furthermore, the memory device 4 may be adapted to supply the first value to the capacitive loading unit 3 in response to the first control signal and to supply the second value to the capacitive loading unit 3 in response to the second control signal. The first control signal may e.g. be a "0". The second control signal may e.g. be a "1". The first control signal may be generated by an external device or internally within the oscillator device 1. The second control signal may be generated by an external device or internally within the oscillator device 1. In an embodiment, the first control signal is supplied to the memory device 4 by applying a "0" to a control terminal of the memory device 4. The second control signal is supplied to the memory device 4 by applying a "1" to the control terminal. Generating the second control signal internally within the oscillator device 1 corresponds to initiating the transition from "0" to "1" internally within the oscillator device 1. Generating at least the second control signal internally within the oscillator device 1 has the advantage that the complexity of the oscillator device and external devices connected to the oscillator device 1 is reduced.

The oscillator core 2 may comprise an enable input terminal for receiving an enable signal for switching the oscillator device 1 from an OFF or idle mode to an ON mode. The enable signal may be generated by an external device, such as a processor 7 or CPU (Central Processing Unit), which runs software to provide the function. The processor 7 may be positioned in an external device. The external device may e.g. be an ASIC (Application Specific Integrated Circuit). Alternatively, the enable signal may be generated by an input interface circuit 17, which is adapted to respond to start-up requests from external devices, in the oscillator device 1.

The first control signal may be generated in response to the enable signal. In response to the first control signal, the capacitance value of the capacitive loading unit 3 is set during a first time period. The capacitive loading during the first time period is sufficiently low to obtain a start-up time that is shorter than the start-up time that would have been obtained if the capacitive loading to be applied during the second time period was used also during the first time period. Thus, the capacitive loading during the first time period is lower than the capacitive loading during the second time period.

The second control signal may be dependent on the amplitude of an oscillator signal generated by the oscillator device 1. The oscillator signal may be an output signal of the oscillator device 1. In order to obtain a stable operating frequency, it is important to have sufficient amplitude of the oscillator signal. When the amplitude of the oscillator signal has reached a certain threshold, a stable operating frequency may be obtained and the capacitive loading of the capacitive loading unit 3 may be set to a value determined by the second value stored in the second memory unit 5b. Detecting the amplitude of the oscillator signal is relatively easy. When the amplitude of the oscillator signal is below a threshold value, the first control signal may be generated. When the amplitude of the oscillator signal is equal to or above the threshold value, the second control signal may be generated.

In an alternative embodiment, the second control signal is generated a predetermined time period after the first control signal or the enable signal has been generated. The predetermined time period is dependent on the capacitance value determined by the first value stored in the first memory unit 5a. The smaller the capacitance value is during the first time period, the shorter the predetermined time period may be, at least up to a certain extent. The second control signal may be generated by a delay circuit included in the oscillator core 2. The delay circuit may be adapted to generate the second control signal in response to the enable signal. The delay circuit may be implemented with, e.g., one or more cascaded and capacitively loaded inverters.

The oscillator core 2 may be adapted to generate at least the second control signal, which may be dependent on the amplitude of the oscillator signal of the oscillator device 1. An amplitude detection unit 8 may be adapted to generate at least the second control signal. In one embodiment, the amplitude detection unit 8 is adapted to generate the first and the second control signal. The amplitude detection unit 8 may generate a signal, which may have a first and a second reference value or state. The first reference value or state may be represented with a voltage that is smaller than 0.2V_{dd}, where V_{dd} is a supply voltage of the oscillator device. The second reference value or state may be represented with a voltage that is larger than 0.8V_{dd}. The signal may be generated in response to detecting the predetermined amplitude threshold value of the oscillator signal. When the first level of the signal generated by the amplitude detection unit 8 is generated, the first control signal is provided. When the second level of the signal generated by the amplitude detection unit 8 is generated, the second control signal is provided.

The amplitude detection unit 8 may be adapted to generate the first and/or the second control signal in dependence of the amplitude of the oscillator signal. For example, the amplitude detection unit 8 may be adapted to generate the first control signal in response to detecting that the amplitude of the oscillator signal is below the predetermined amplitude threshold value. The amplitude detection unit 8 may be also adapted to generate the second control signal in response to detecting that the amplitude of the oscillator signal is equal to or higher than the predetermined amplitude threshold value. For example, the predetermined amplitude threshold value may be in the range of hundreds of mV.

The first and the second memory units 5a, 5b may be digital memory units. In an embodiment, the memory units 5a, 5b are digital memory registers. Thus, the first and the second values to be stored in the first and the second memory units 5a, 5b, respectively, may be digital values.

The capacitive loading unit 3 may include at least one digitally controllable capacitor circuit. Each digitally controllable capacitor circuit may e.g. be implemented with a varactor. Alternatively, each digitally controllable capacitor circuit includes a capacitor ladder.

The oscillator device 1 may include an input interface circuit 17 adapted to provide the enable signal in response to a start-up request from an external device. The start-up request may e.g. be issued by the processor 7 of the external device and may be received at an input terminal of the input interface circuit 17. The input interface circuit 17 may e.g. be implemented with a resistive component, such as a pull-down resistor, connected to ground and the input terminal of the input interface circuit 17. The use of a pull-down resistor allows one or more external devices to be connected to the input terminal of the input interface circuit 17. The external device may issue the start-up request by supplying a voltage having a first level, corresponding to a "1", to the input terminal of the interface circuit 17. If no start-up request has been issued by an external device, i.e., no external voltage is supplied to the input terminal of the input interface circuit 17, then the voltage at the input terminal of the input interface circuit 17 is pulled to a second level, corresponding to a "0", through the pull-down resistor. The first voltage level may be higher than the second voltage level. The input terminal of the input interface circuit 17 may also be connected to buffers in the input interface circuit 17 driving the enable signal internally in the oscillator device 1.

In an embodiment, the value stored in at least the second memory unit 5b may be varied, e.g., by the processor 7. Varying the value stored in the second memory unit 5b during the second time period changes the capacitance of the capacitive loading unit 3 during the second time period and, hence, the frequency of the oscillator device 1. Hence, allowing the value stored in the second memory unit 5b to be varied provides for tunability of the oscillator frequency during the second time period.

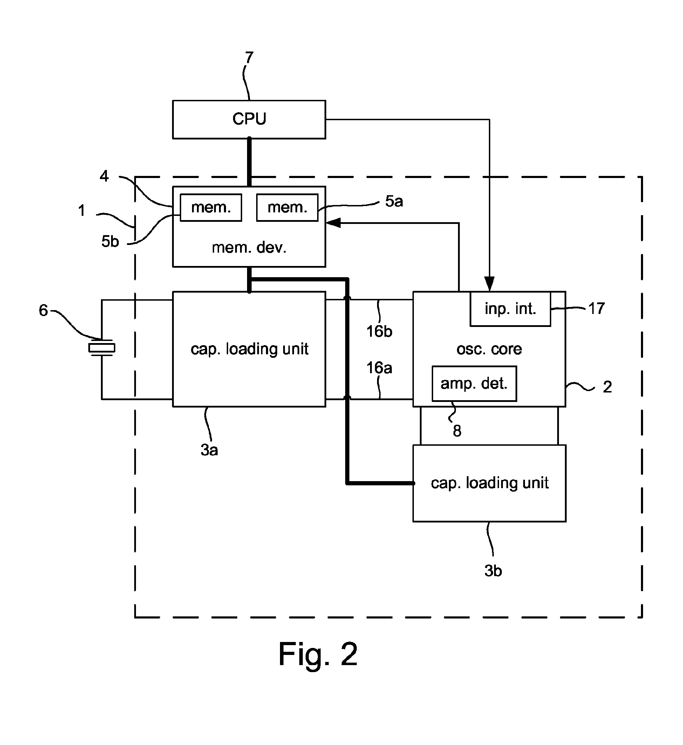

Fig. 2 illustrates an alternative embodiment of the oscillator device 1. The embodiment of Fig. 2 comprises a first and a second capacitive loading unit 3a, 3b. The first loading unit 3a may have controllable capacitance values adapted to provide coarse tuning of the oscillator core 2. The second loading unit 3b may have controllable capacitance values adapted to provide fine tuning of the oscillator core 2. Thus, the difference between capacitance values, which may be provided by the first capacitive loading unit 3a, may be larger than the difference between capacitance values, which may be provided by the second capacitive loading unit 3b. The tuning control may be provided during the second time period of the oscillator device 1. The difference between the oscillator core 2 of the embodiment of Fig. 1 and the oscillator core of the embodiment of Fig. 2 is the number of input terminals for connection to the capacitive loading units 3, 3a, and 3b, respectively.

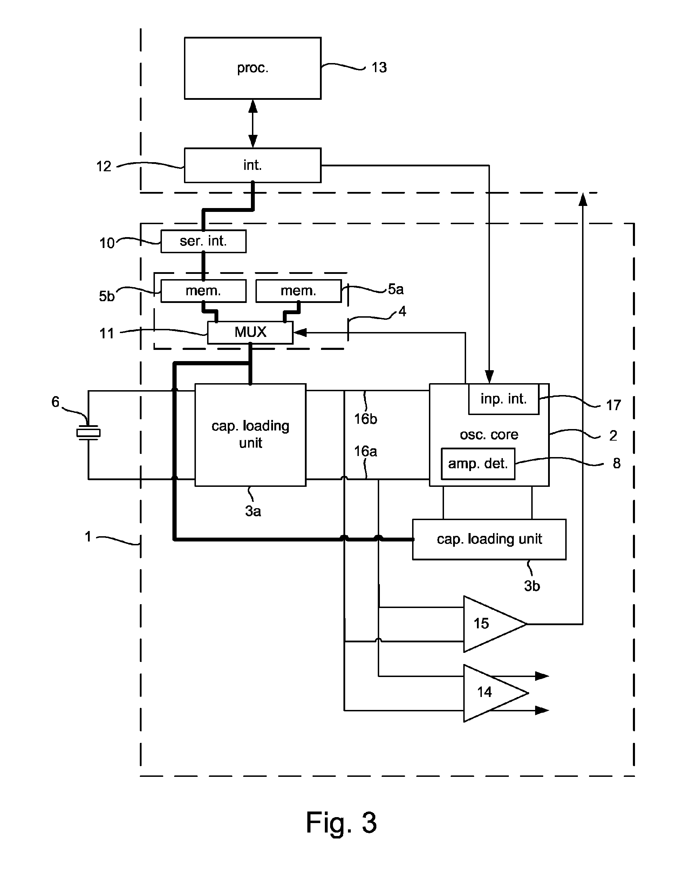

Fig. 3 illustrates one embodiment of the oscillator device 1, wherein the memory device 4 is shown in more detail. The memory device 4 may be connected to a serial control interface 10. Also, the memory device 4 may comprise a multiplexer unit 11 besides the memory units 5a and 5b. The first memory unit 5a may be a hardcoded memory unit. Thus, the first value of the memory device 4 stored in the first memory unit 5a may be fixed. For example, the first memory unit 5a may be hardcoded by connecting input terminals of the multiplexer unit 11 associated with the first memory unit 5a directly to ground or the supply voltage for storing a logic '0' and a logic '1', respectively. Alternatively, the first memory unit 5a is reprogrammable. Having a fixed value stored in the first memory unit 5a has the advantage that it reduces complexity. The first value may be used to set the capacitance value of the capacitive loading unit 3a, 3b during the first time period. The value of the second memory unit 5b is used to set the capacitance value of the capacitive loading unit 3a, 3b, and thus also set a frequency of oscillation of the oscillator device 1, during the second time period. It is an advantage if the second memory unit 5b is reprogrammable. Then, an external device may provide tuning control of the frequency of the output signal of the oscillator device 1 by providing a new value to be stored in and outputted by the second memory unit 5b when the oscillator device 1 is in operation. The tuning control may be provided by a processor 13 of the external device.

The serial interface 10 may be adapted to receive a digital value from an interface 12 connected to the processor 13, or directly from the processor 13, of the external device over a serial bus. The serial interface 10 is adapted to input the received data of the digital value into the second memory unit 5b. The serial interface 10 may also be adapted to communicate data to other units located on the same chip as the oscillator device.

The multiplexer 11 has at least one control terminal connected to the control terminal of the oscillator device 1 for receiving the first and the second control signals. Also, the multiplexer device comprises a first and a second input terminal connected to the first and the second memory units 5a, 5b, respectively. The multiplexer 11 may be adapted to output the value stored in the first memory unit 5a in response to the first control signal. Also, the multiplexer 11 may be adapted to output the value stored in the second memory unit 5b in response to the second control signal.

When the oscillator device 1 should be switched over to the operative phase, the last value programmed into the second memory unit 5b may be applied. Thus, the second memory unit 5b does not have to be reprogrammed, i.e. a new value does not have to be supplied to the second memory unit 5b, before a useful oscillator signal may be generated. Instead, the last value stored in the second memory unit 5b may be reused. Consequently, a useful oscillator signal may be generated without involvement of any external device.

Also shown in Fig. 3 is a buffer 14 which may be used to distribute a clock signal derived from the output signal of the oscillator device 1 to devices, such as RF (Radio Frequency) devices, located on the same chip as the oscillator device, and a buffer 15 which may be used to distribute a clock signal to external devices, such as the processor 13. In Fig. 3, the buffer 14 distributes a differential clock signal. In an alternative embodiment, the buffer 14 may distribute a single-ended clock signal. In Fig. 3, the buffer 15 distributes a single-ended clock signal. In an alternative embodiment, the buffer 15 may distribute a differential clock signal.

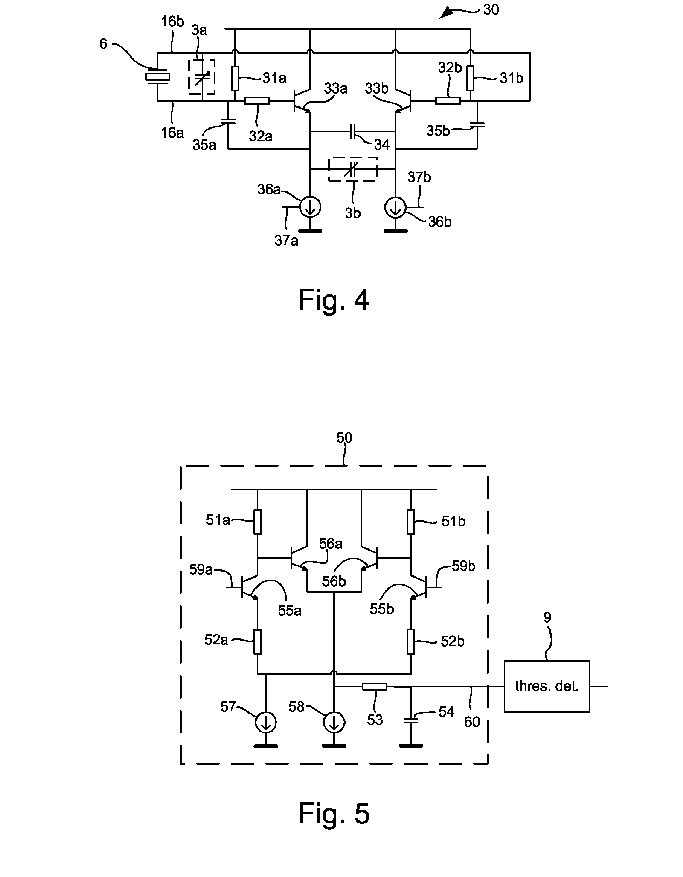

Fig. 4 illustrates one embodiment of a differential crystal oscillator. The differential crystal oscillator in Fig. 4 comprises variable capacitive loading units 3a and 3b, crystal 6, and a differential amplifier 30, which is part of the oscillator core 2. The differential amplifier 30 includes resistors 31a, 31b, 32a, and 32b, transistors 33a and 33b, capacitors 34, 35a, and 35b, and controllable current sources 36a and 36b. Transistors 33a and 33b may be bipolar or CMOS transistors. The differential crystal oscillator, and hence the oscillator device 1, may be switched into stand-by mode by switching off the currents in the current sources 36a and 36b by applying appropriate signals, such as signals having voltage levels adapted to switch off the current sources, at control terminals 37a and 37b, respectively. Further, the differential crystal oscillator, and hence the oscillator device 1, may be enabled by switching on the currents in the current sources 36a and 36b by applying appropriate signals, such as signals having voltage levels adapted to switch on the current sources, at the control terminals 37a and 37b, respectively. The signals applied at the control terminals 37a and 37b in order to switch the current sources 36a and 36b off and on may be derived from the enable signal. A bandgap reference circuit controlled by the enable signal may be provided to generate said voltage levels adapted to switch the current sources 36a and 36b off and on.

Fig. 5 illustrates an embodiment of the amplitude detection unit 8. The amplitude detection unit may comprise an AM detector 50. The AM-detector 50 comprises resistors 51a, 51b, 52a, 52b, and 53, capacitor 54, transistors 55a, 55b, 56a, 56b, and current sources 57 and 58. Transistors 55a, 55b, 56a, 56b may be bipolar or CMOS transistors. Input terminals 59a and 59b are adapted to be connected to the differential crystal oscillator output terminals 16a and 16b, respectively. When the amplitude of a differential signal present at the input terminals 59a and 59b increases, the voltage at the output terminal 60 also increases. Hence, the voltage at the output terminal 60 may be used to detect when the amplitude of the output signal equals or exceeds a predetermined threshold value. For that purpose, the output terminal 60 may be connected to a threshold detector 9 that may generate valid logic levels representing "0" and "1", where "0" may be the first control signal and "1" may be the second control signal to be supplied to the control terminal of the memory device 4. The threshold detector 9 may be implemented, e.g., with a comparator or one or more cascaded inverters. Alternatively, the threshold detector 9 may be implemented with a Schmitt trigger. The output terminal of the threshold detector 9 may be operatively connected to the control terminal of the memory device 4.

Furthermore, the AM detector 50 may form part of an Automatic Gain Control (AGC). In an AGC implementation, the voltage at output terminal 60 may be operative to control the current drawn in the oscillator core 2. Referring to the embodiment illustrated in Fig.4, this may be performed by supplying the voltage present at the output terminal 60 of the AM detector 50, or a voltage derived therefrom, to the control terminals 37a and 37b of the differential amplifier 30. Consequently, the loop gain in the oscillator core 2 can be controlled. Using at least a portion of an AGC to provide the amplitude detection unit 8 is an advantage as the complexity of the system is further decreased when a single unit is used for several functions, such as loop gain control and amplitude detection. However, it is possible to use a separate amplitude detection unit.

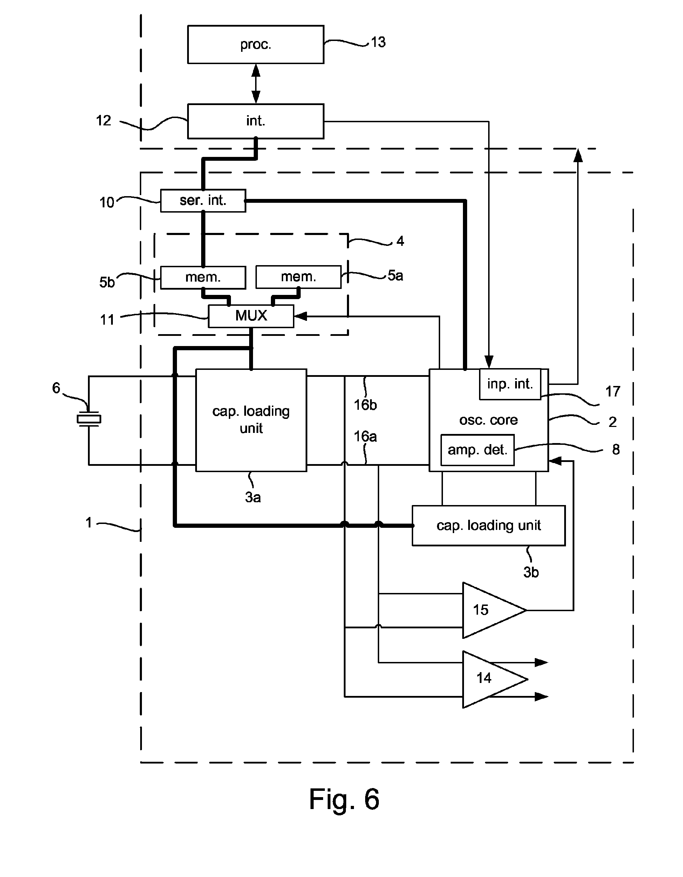

Fig. 6 illustrates an embodiment, wherein the output from the buffer 15 is supplied to the oscillator core 2. The output from the buffer 15 may be supplied to the amplitude detection unit 8 for generation of the first and/or second control signals. The oscillator core 2 may in turn forward the output from the buffer 15 or a signal derived therefrom as a clock signal to external devices, such as the processor 13. Further, the serial control interface 10 of the memory device 4 may be connected to the oscillator core 2 to allow programmability of the amplitude detection unit 8 in the oscillator core 2. For example, the amplitude detection unit may be programmed to compensate for varying conditions caused by, e.g., temperature changes, ageing of the components in the oscillator device 1, and variations between individual oscillator devices 1.

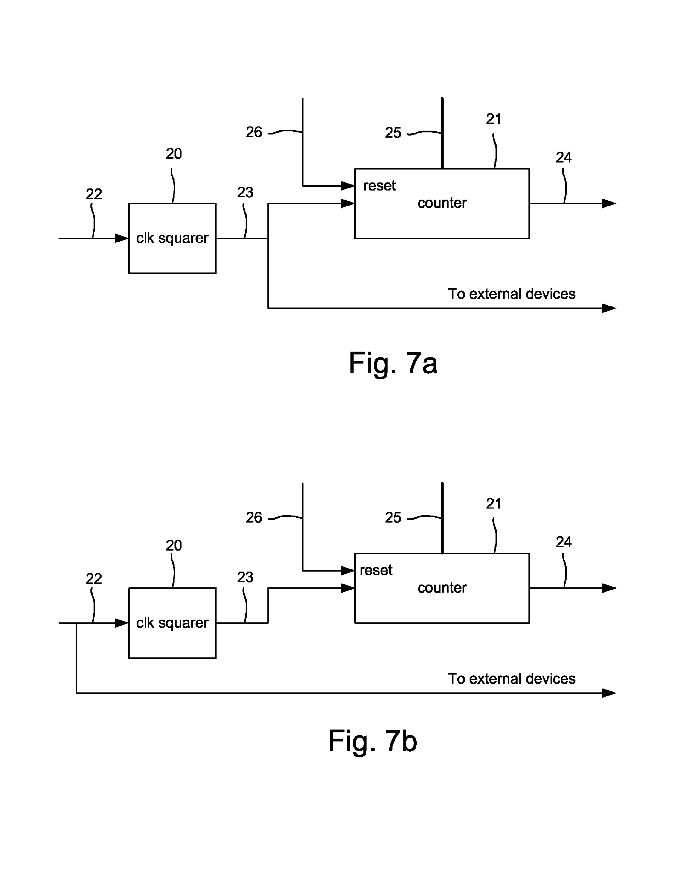

Fig. 7a shows an embodiment of the amplitude detection unit 8 that may be used in the embodiment of the oscillator core illustrated in Fig. 6. The output from the buffer 15 is supplied to an input terminal 22 of a clock squarer 20. The clock squarer 20 may be adapted to generate a square wave at an output terminal 23 of the clock squarer 20 in response to that a periodic signal is supplied to the input terminal 22 of the clock squarer 20. The clock squarer 20 may include a Schmitt trigger. The output terminal 23 of the clock squarer 20 is connected to a clock input terminal of a counter 21, which may be reset by a rising edge of the enable signal supplied to a reset terminal 26 of the programmable counter 21. When said output from the buffer 15 has reached an amplitude sufficiently large for the clock squarer to generate a square wave at its output 23, the counter 21 starts to count until it reaches a stop value. When the counter 21 reaches the stop value, it generates the second control signal at its output 24. In other words, the clock squarer 20 is used to detect when the amplitude of the output from the buffer 15 exceeds a predefined threshold level. The threshold level may be the amplitude level when the clock squarer starts to generate a square wave. After that said amplitude level has been detected by the clock squarer 20, the amplitude detection unit 8 waits for a period of time, the length of which is set by the stop value of the counter 21, before the second control signal is generated. This is to allow the oscillator signal of the oscillator device 1 to reach a sufficient amplitude in order to obtain a stable operating frequency before the second value stored in the memory device 4 is supplied to the capacitive loading unit 3, 3a, 3b. The length of the time period necessary to ensure a sufficient amplitude of the oscillator signal of the oscillator device 1 may vary, e.g. with temperature and age of the oscillator device 1. It may also vary between individual oscillator devices 1. Therefore, the stop value of the counter 21, and, hence, the length of the time period, may be programmed over the bus 25 from the serial control interface 10, which is connected to the oscillator core 2 in the embodiment illustrated in Fig. 6.

Fig. 7b shows another embodiment of the amplitude detection unit 8 that may be used in the embodiment of the oscillator core 2 illustrated in Fig. 6. In this embodiment, the generation of the second control signal is identical to that of the embodiment shown in Fig. 7a, as is the programming of the stop value in the counter 21. In the embodiment of Fig 7a, it is the signal at the output 23 of the clock squarer 20 that is forwarded as a clock signal to the external devices, such as the processor 13, by the oscillator core 2. In the embodiment of Fig 7b, it is the signal at the input 22 of the clock squarer 20 that is distributed as a clock signal to the external devices.

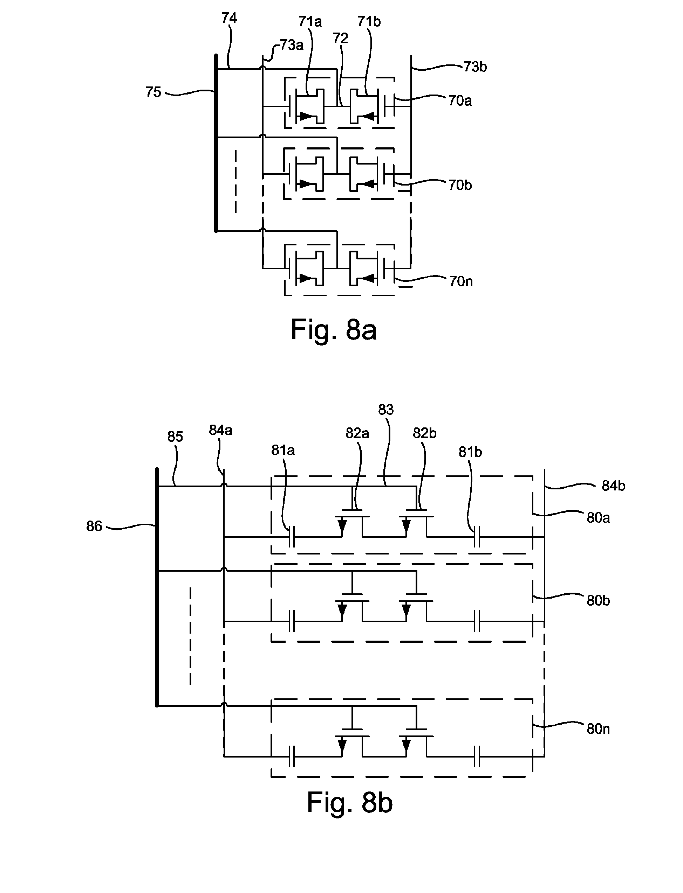

Fig. 8a illustrates an embodiment of the capacitive loading unit 3 embodied as a capacitor ladder. The capacitor ladder comprises a plurality of capacitor devices 70a, 70b, ...70*n*. The capacitor devices have equivalent design and function. Therefore, only capacitor device 70a will be described. Capacitor device 70a may be implemented with transistors, such as MOS transistors. Capacitor device 70a comprises a first transistor 71a and a second transistor 71b. The source and drain terminals of transistors 71a and 71b are all connected to a common node 72. The gates of the transistors 71a and 71b may be connected to terminals 73a and 73b of the capacitor ladder, respectively. The capacitor device 70a may have a first and a second state, such as on and off, with different associated capacitance values. The state may be controlled by one bit 74 of a digital control word supplied to the common node 72. The digital control word may be supplied over a bus 75. The number of bits in the control word supplied over the bus 75 is the same as the number of capacitor devices. Different values of the digital control word supplied over the bus 75 result in different capacitance values for the capacitive loading unit illustrated in Fig. 8a.

Fig. 8b illustrates another embodiment of the capacitive loading unit 3 embodied as a capacitor ladder. The capacitor ladder comprises a plurality of capacitor devices 80a, 80b, ...80*n* with essentially the same functionality as the capacitor devices 70a, 70b, ...70*n* illustrated in Fig. 8a. The capacitor devices 80a, 80b, ...80*n*, each has equivalent design and function. Therefore, only capacitor device 80a will be described. Capacitor device 80a may comprise two capacitors 81a and 81b. A first terminal of capacitor 81a is connected to a first output terminal 84a of the capacitor ladder. A second terminal of capacitor 81b is connected to a second terminal 84b of the capacitor ladder. The capacitor device 80a may have a first and a second state, such as on and off, with different associated capacitance values. In the on state, transistors 82a and 82b are in a conducting state and the capacitors 81a and 81b are connected in series. In the off state, the transistors 82a and 82b are in a nonconducting state and the capacitors 81a and 81b are disconnected. The gate terminals of the transistors 82a and 82b, which also may be provided by MOS transistors, are connected to a common node 83. The state may be controlled by one bit 85 of a digital control word supplied to the common node 83. The digital control word may be supplied over a bus 86. The number of bits in the control word supplied over the bus 86 is the same as the number of capacitor devices. Different values of the digital control word supplied over the bus 86 result in different capacitance values for the capacitive loading unit illustrated in Fig. 8b.

Either of the capacitor ladders of Figs. 8a and 8b, which form capacitive circuits, may be utilized as the capacitive loading unit 3 in the embodiment of Fig. 1. The capacitor ladder of Fig. 8a may be used as the first capacitive loading unit 3a and the capacitor ladder of Fig. 8b may be used as the second capacitor ladder 3b, or vice versa, in the embodiments of Figs. 2, 3, and 6. Alternatively, both the first and the second capacitive loading unit 3a, 3b are provided by the capacitor ladder of Fig. 8a or the capacitor ladder of Fig. 8b in the embodiments of Figs. 2, 3, and 6. The control words supplied over buses 75 and 86 may be supplied by the values stored in either memory unit 5a or memory unit 5b.

Different approaches may be used for the implementation in terms of choosing the capacitance values of the capacitor devices in the capacitor ladders. For example, a binary-weighted approach can be used, wherein the on-state capacitance of the capacitor device associated with the k:th bit is 2^{k-1} times a unit capacitance. This solution provides low complexity in that it allows the control word 75, 86 to be in binary representation resulting in a small number of bits. However, the binary-weighted approach may be susceptible to capacitance mismatch caused by parameter variations in components. An alternative solution is to use a thermometer-coded approach, wherein the on-state capacitance of all capacitor devices are equal. This approach is less susceptible to capacitor mismatch than the binary-weighted approach and guarantees that the capacitance of the capacitor ladder is a monotonic function of the control signal represented with the control word 75, 86. However, the thermometer-coded approach may result in a higher complexity since the control word 75, 86 is in thermometer-coded representation, which requires more bits than the binary-weighted approach. A hybrid between the binary-weighted and thermometer-coded approaches, wherein a first part of the control word 75, 86 is in binary representation and a second part is thermometer-coded, is an alternative approach.

In alternative embodiments, at least one capacitive loading unit 3, 3a, 3b, may be realized with a varactor diode which is digitally controlled via a digital-to-analog converter. In further alternative embodiments, at least one capactive loading unit may be realized with a capacitor ladder digitally controlled via a sigma-delta modulator. The digitally controlled capacitor ladder may comprise a single capacitance, which is switched in/out by the sigma-delta modulator.

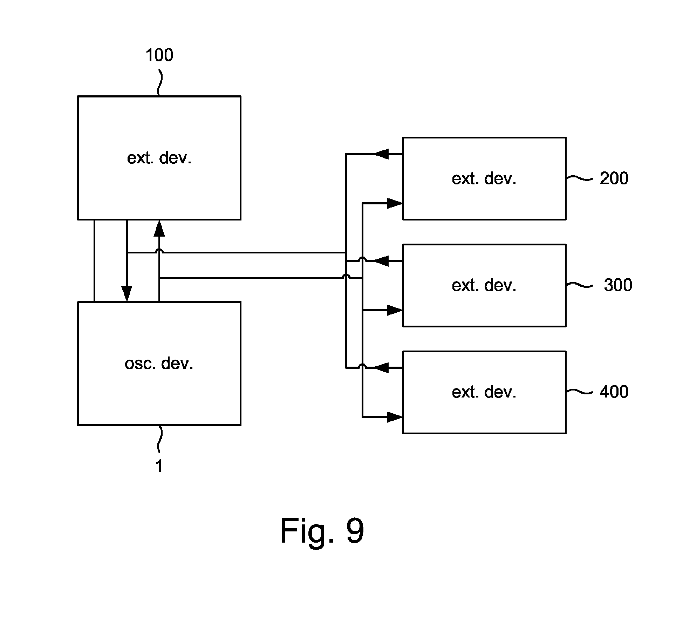

Fig. 9 illustrates an embodiment wherein the oscillator device 1 is connected to a plurality of external devices. The oscillator device itself may e.g. by provided within an RF (Radio Frequency) ASIC. A first external device 100 may e.g. be a digital baseband ASIC, which requires a clock signal provided by the oscillator signal. In a communication apparatus, such as a mobile telephone, other functionalities may require a clock signal. A second external device 200 requiring a clock signal may be a short-range communication unit, such as a Bluetooth radio transceiver. A third external device 300 requiring a clock signal may be a WLAN (Wireless Local Area Network) communication unit. A fourth external device 400 requiring a clock signal may be a GPS (Global Positioning System) unit. Each of the external devices 100, 200, 300, 400 may have an output terminal and an input terminal connected to input and output terminals, respectively, of the oscillator device 1. Clock signal request messages may be issued on the output terminals of the external devices to the input of the input interface circuit 17 of the oscillator device 1. The clock signal, i.e. the output signal of the oscillator device 1, may be received at their input terminals in response thereto.

According to the embodiments of the present invention, any of external devices 200, 300, 400 may request a clock signal. Consequently, short start-up time of the oscillator device 1 may be provided without having to power up the external device 100 or implement software in any of the external devices 200, 300, 400 to control the start up. Hence, system design becomes less complex.

In Figs. 1-6, the oscillator core 2 is shown with a differential structure. Alternatively, the oscillator core 2 may have a single-ended structure.

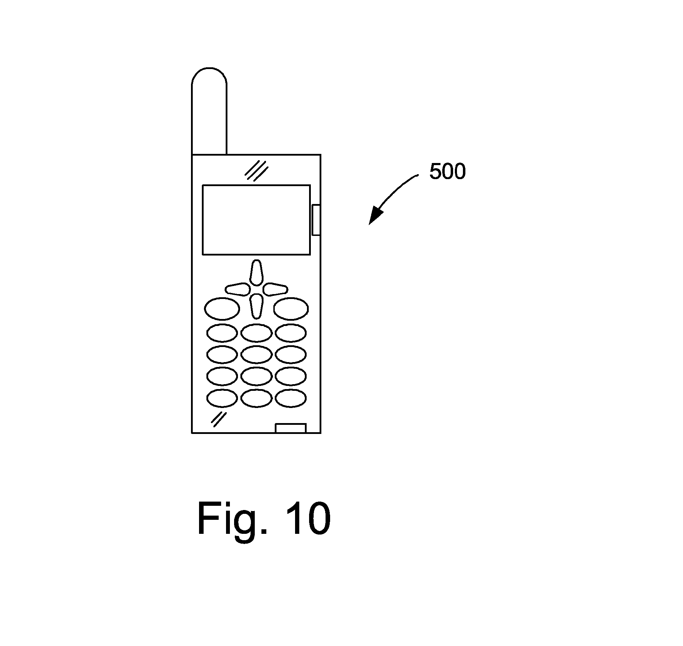

Fig. 10 illustrates an electronic device 500 in which the oscillator device 1 may be implemented. The electronic device may also comprise any one of the external devices 100, 200, 300, 400. The electronic device 500 may e.g. be a portable or handheld mobile radio communication equipment, a mobile radio terminal, a mobile telephone, a pager, a communicator, an electronic organizer, a smartphone or a computer. In the embodiment shown, the electronic device is a mobile telephone.

The output signal from the oscillator device 1 may provide a clock signal. The clock signal may be the first clock signal that is provided in a system, wherein several devices, such as externals devices 100, 200, 300, 400, require a clock signal. The clock signal may also be the only clock signal provided in the system.

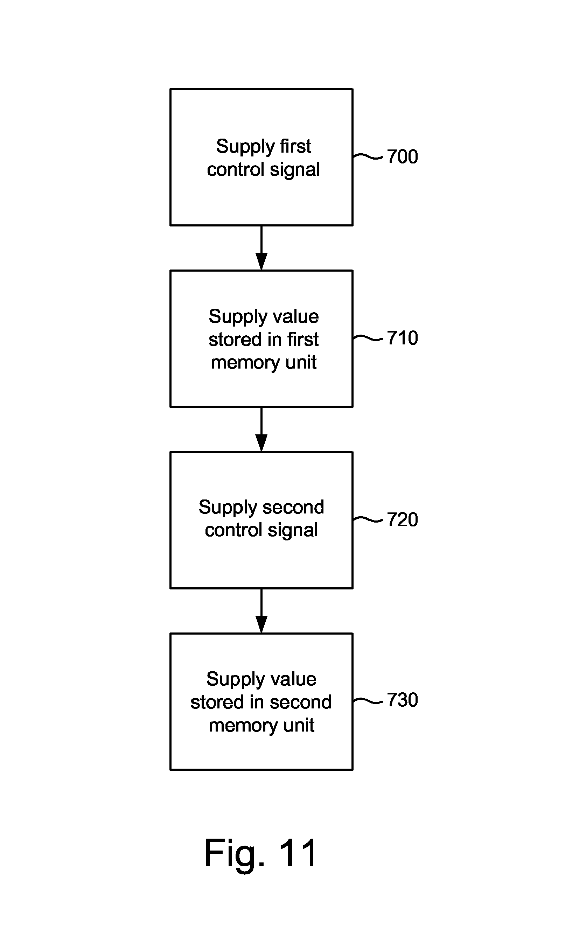

According to a further aspect of the invention, a method for fast start up of an oscillator device 1, illustrated with a flow chart in Fig. 11, is provided. The method comprises the steps of:
- Supplying a first control signal to the memory device 4 during a first time period in step 700;
- Supplying the value stored in the first memory unit 5a to the capacitive loading unit for controlling the capacitance value during the first time period in response to the first control signal in step 710;
- Supplying a second control signal to the memory device 4 during a second time period in step 720; and
- Supplying the value stored in the second memory unit 5b to the capacitive loading unit for controlling the capacitance value during the second time period in response to the second control signal in step 730.

In an embodiment, the method further comprises the step of determining a starting-time instant for the second time period. The starting-time instant for the second time period may be determined based upon when the amplitude of an oscillator signal exceeds a predetermined threshold value, as discussed above with regard to some of the embodiments of the oscillator device 1. The starting-time instant for the second time period may also be determined as a time instant occuring a predetermined amount of time after the reception of an enable signal at the oscillator core 2, as discussed above with regard to embodiments of the oscillator device 1.

The present invention has been described above with reference to specific embodiments. However, other embodiments than the above described are possible within the scope of the invention. Different method steps than those described above, performing the method by hardware or software, may be provided within the scope of the invention. The different features and steps of the invention may be combined in other combinations than those described. The scope of the invention is only limited by the appended patent claims.

## Claims

1. An oscillator device (1), comprising
an oscillator core (2); and
a capacitive loading unit (3, 3a, 3b) having a controllable capacitance value and being connected to the oscillator core (2);
**characterized by**
a memory device (4) including a first and a second memory unit (5a, 5b) and being connected to the capacitive loading unit; wherein
the first memory unit (5a) is adapted to store a first value to be supplied to the capacitive loading unit (3, 3a, 3b) for controlling the capacitance value during a first time period;
the second memory unit (5b) is adapted to store a second value to be supplied to the capacitive loading unit (3, 3a, 3b) for controlling the capacitance value during a second time period.

2. The oscillator device according to claim 1,
wherein the memory device (4) includes at least one control terminal for receiving a first and a second control signal, and is adapted to supply the first value to the capacitive loading unit (3, 3a, 3b) in response to the first control signal and to supply the second value to the capacitive loading unit (3, 3a, 3b) in response to the second control signal.

3. The oscillator device according to claim 2,
wherein the oscillator core (2) is adapted to generate at least the second control signal, which is dependent on the amplitude of an oscillator signal of the oscillator device (1).

4. The oscillator device according to claim 3,
wherein the oscillator core includes an amplitude detection unit (8) adapted to generate at least the second control signal in dependence of the amplitude of the oscillator signal.

5. The oscillator device according to claim 4,
wherein the amplitude detection unit (8) is adapted to generate the second control signal when the amplitude of the oscillator signal exceeds a predefined threshold value.

6. The oscillator device according to any of claims 4 or 5, wherein the amplitude detection unit (8) forms part of an Automatic Gain Control unit.

7. The oscillator device according to claims 4,
wherein the amplitude detection unit (8) comprises a clock squarer (20) operatively connected to an oscillator output and to a counter (21), wherein the clock squarer (20) is adapted to generate a square wave in response to that the amplitude of said oscillator signal exceeds a predefined threshold value, and the counter (21) is adapted to start counting when the clock squarer (20) starts to generate the square wave and to generate the second control signal when it reaches a stop value.

8. The oscillator device according to claim 7,
wherein the stop value of the counter (21) is programmable.

9. The oscillator device according to claim 2,
wherein the oscillator core (2) includes a delay circuit adapted to generate the second control signal in response to an enable signal and within a predetermined time period after having received the enable signal.

10. The oscillator device according to any of the previous claims, wherein the first and second memory units (5a, 5b) are registers.

11. The oscillator device according to any of the previous claims, wherein the capacitive loading unit (3, 3a, 3b) includes at least one digitally controllable capacitor circuit.

12. The oscillator device according to claim 11,
wherein each digitally controllable capacitor circuit includes at least one capacitor ladder.

13. The oscillator device according to any of the previous claims, wherein the oscillator device (1) further comprises:
an input interface circuit (17) adapted to provide the enable signal in response to a start-up request.

14. The oscillator device according to claim 13,
wherein the input interface circuit (17) is connected to at least one external device (100, 200, 300, 400) adapted to generate the start-up request.

15. An electronic device (500), comprising the oscillator device according to any of the claims 1-14.

16. The electronic device according to claim 15,
wherein the electronic device is a portable or handheld mobile radio communication equipment, a mobile radio terminal, a mobile telephone, a pager, a communicator, an electronic organizer, a smartphone or a computer.

17. A method for start-up of an oscillator device (1), the oscillator device including
an oscillator core (2);
a capacitive loading unit (3, 3a, 3b) having a controllable capacitance value and being connected to the oscillator core (2);
a memory device (4) operatively connected to the capacitive loading unit (3, 3a, 3b) and to the oscillator core (2), the memory device (4) including a first and a second memory unit (5a, 5b)
wherein the method comprises:
- supplying a first value stored in the first memory unit (5a) to the capacitive loading unit for controlling the controllable capacitance value during the first time period (710); and
- supplying a second value stored in the second memory unit (5b) to the capacitive loading unit for controlling the capacitance value during the second time period (730).

18. The method according to claim 17, wherin the method includes the step of:
- determining the starting-time instant for the second time period.

19. The method according to claim 18, wherein the step of determining the starting-time instant for the second time period includes:
- measuring the amplitude of an oscillator signal; and
- choosing the starting-time instant for the second time period as the time instant when the oscillator signal exceeds a predetermined threshold value.

20. The method according to claim 18, wherein the step of determining the starting-time instant for the second time period includes:
- receiving an enable signal at the oscillator core (2); and
- choosing the starting-time instant for the second time period as a time instant occurring a predetermined amount of time after the reception of the enable signal.
